Europäisches Patentamt

European Patent Office

Office européen des brevets

(11) Publication number: **0 452 869 A1**

## EUROPEAN PATENT APPLICATION

(21) Application number: 91106033.3

(22) Date of filing: 15.04.91

(51) Int. Cl.5: **H01L 29/76,** H01S 3/19, H01L 21/203

(30) Priority: 16.04.90 JP 99990/90

(43) Date of publication of application:
23.10.91 Bulletin 91/43

(84) Designated Contracting States:
**DE FR GB IT NL**

(71) Applicant: CANON KABUSHIKI KAISHA
30-2, 3-chome, Shimomaruko, Ohta-ku
Tokyo(JP)

(72) Inventor: Miyazawa, Seiichi, c/o Canon
Kabushiki Kaisha
30-2, 3-chome, Shimomaruko, Ohta-ku
Tokyo(JP)

(74) Representative: Bühling, Gerhard, Dipl.-Chem.
et al
Patentanwaltsbüro Tiedtke-Bühling-Kinne
Grupe-Pellmann-Grams Bavariaring 4
W-8000 München 2(DE)

(54) Semiconductor device and method of making the same.

(57) This specification discloses a semiconductor device which comprises a plurality of semiconductor layers formed on a substrate and including an active layer and formed of one of GaAs and AlGaAs and which does not have any GaAs layer having a thickness exceeding 500 Å between the substrate and the active layer. The specification also discloses a method of making a semiconductor device comprising a substrate and a plurality of semiconductor layers including an active layer formed on the substrate. The method comprises the steps of rendering the temperature of the substrate into 500°C or lower, and growing on the substrate a semiconductor layer formed of AlGaAs, and rendering the temperature of the substrate into 500°C or lower, and growing an active layer on the AlGaAs layer without interposing a GaAs layer having a thickness exceeding 500 Å between the substrate and the AlGaAs layer.

FIG. 8

EP 0 452 869 A1

## BACKGROUND OF THE INVENTION

### Field of the Invention

This invention relates to a semiconductor device such as a semiconductor laser or a field effect type transistor (FET) and a method of making the same, and particularly to a semiconductor device comprising a substrate and a plurality of semiconductor layers of GaAs or AlGaAs formed thereon, and a method of making the same.

### Related Background Art

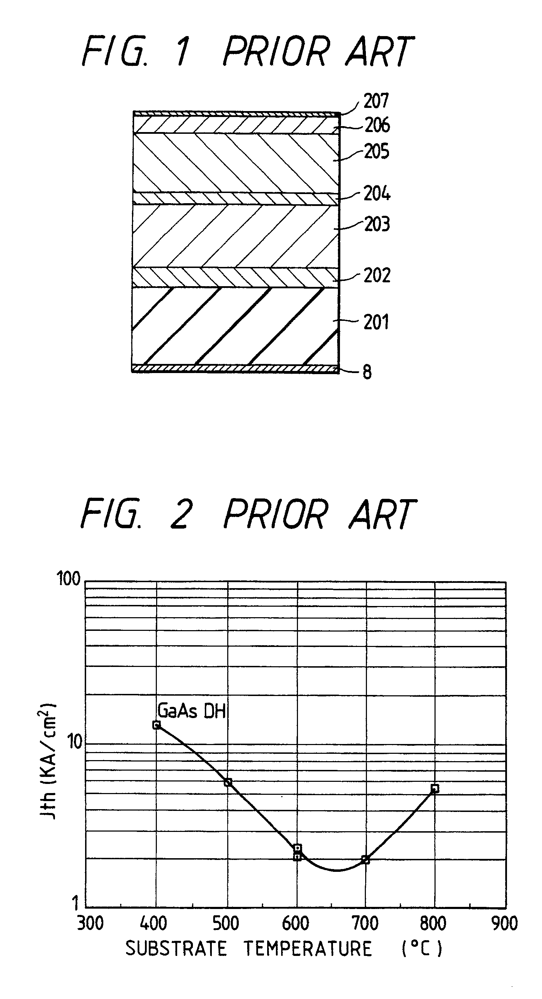

It is reported, for example, in Appl. Phys. Lett., Vol. 36, p. 118 (1980), W. T. Tsang et al. that the characteristic of a semiconductor laser made by molecular beam epitaxy (MBE), i.e., the lowness of the threshold current value thereof, drops in the relatively low temperature range of growth temperature, i.e., substrate temperature. Figure 1 of the accompanying drawings is a schematic cross-sectional view showing an example of such a prior-art semiconductor laser. Figure 2 of the accompanying drawings shows the relation between the threshold value current density Jth in the semiconductor laser of Figure 1 and the substrate temperature during making.

In Figure 1, the reference numeral 201 designates an n-GaAs substrate, the reference numeral 202 denotes an Si-doped GaAs layer having a thickness of 0.5 $\mu$m which is a buffer layer, the reference numeral 203 designates an Si-doped $Al_{0.3}Ga_{0.7}As$ clad layer having a thickness of 1.5 $\mu$m, the reference numeral 204 denotes an active layer having a thickness of 1 $\mu$m formed of un-doped GaAs, the reference numeral 205 designates a Be-doped $Al_{0.3}Ga_{0.7}As$ clad layer having a thickness of 5 $\mu$m, the reference numeral 206 denotes a Be-doped GaAs layer which is a contact layer having a thickness of 0.5 $\mu$m, the reference numeral 207 designates a Cr/Au alloy electrode deposited on the contact layer 206, and the reference numeral 208 denotes an AuGe/Ni/Au electrode deposited on the back of the substrate after the n-GaAs substrate 201 is made thin to the order of 100 $\mu$m.

In Figure 2 showing the substrate temperature dependency of Jth (threshold value current density) of the laser thus made and having a stripe width of 100 $\mu$m and a cavity length of 300 $\mu$m, it is shown that in such a laser, Jth becomes smaller in the vicinity of a substrate temperature 650°C, that is, the characteristic becomes better. It is seen that in the vicinity of a substrate temperature 300°C, Jth assumes a value of 14 KA/cm$^2$ or greater and exceeds much far the threshold current value of about 3 kA/cm$^2$ usable as a laser and in such a low temperature range, the characteristic as a laser is deteriorated.

Now, in recent years, attention has been paid to an integrated circuit (OEIC) of an optical device and an electrical or electronic device. For example, as an announced study of such OEIC, there is J. Vac. Sci. Technol. B2(2), 259 (1984), Very Low Threshold Current GaAs-AlGaAs GRINSCH Lasers Grown by MBE for OEIC Applications. OEIC has characteristics such as improved reliability, reduced cost and compactness and is regarded as an important technique, but a problem which arises when it is integrated is the temperature of manufacture.

That is, the problem is that according to the conventional manner, the temperature of manufacture when the device is made, i.e., the substrate temperature, is hight and therefore the mutual diffusion of constituent elements and impurities occurs and an ideal doping profile (distribution) and ideal structure cannot be made. Optical devices such as semiconductor lasers are made usually at 600°C or higher as previously described and nowadays, they are made at higher temperatures of the order of 700°C for the purposed of improving the performance thereof. In contrast, electrical devices are made chiefly at a growth temperature in the vicinity of 500°C because they are apt to easily suffer from the mutual diffusion or the like of impurities. That is, here is already given birth to a temperature difference of the order of 200°C.

Thus, to achieve the integration of OEIC without deteriorating the characteristic of an electrical device, the electrical device is made always after an optical device is made. Consequently, a plurality of epitaxial grows differing in structure becomes impossible.

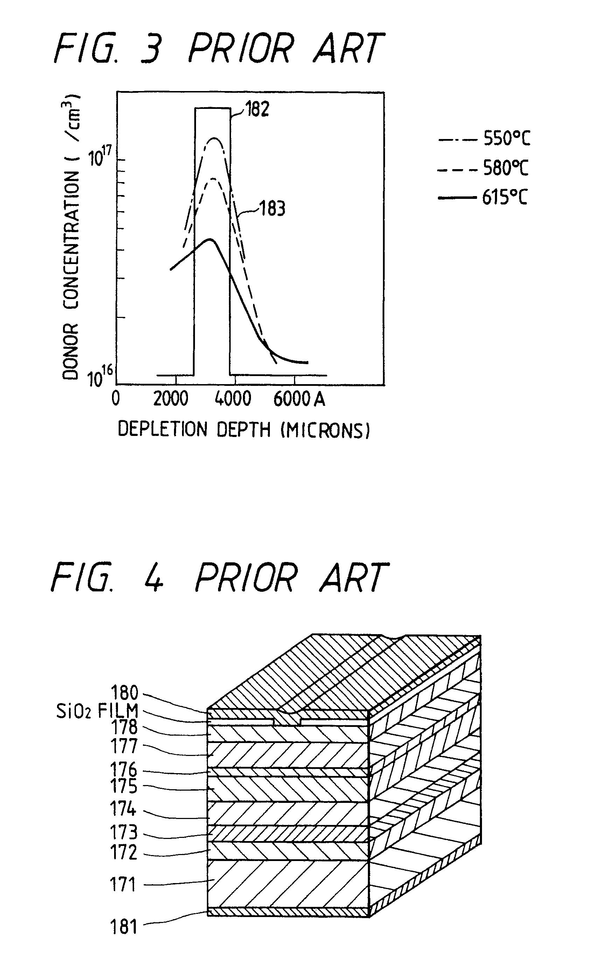

An example of the diffusion of Sn-doped GaAs is actually shown in Figure 3 of the accompanying drawings. It is seen that as indicated by a dot-and-dash line 183, the structure has already broken more greatly than an ideal doping shape 182 at a growth temperature of 550°C.

As noted above, low-temperature growth is a very important technique in the semiconductor process, and is particularly the low-temperature growth of a semiconductor laser which provides the center of an optical device is important to the technique of integrating an optical device and an electrical device.

Next, what has recently been drawing particular attention in connection with heterojunction having lattice uncomformity includes the study of heteroepitaxy for growing a III-V group compound semiconductor such as GaAs on an Si substrate. If GaAs or the like can be grown on an Si substrate, there will be provided an inexpensive substrate of large area, and this will lead to such expected merits as ① the possibility of providing a solar cell of high efficiency, ② the possibility of making Si and GaAs monolithic and realizing an opto-electronic integrated circuit (OEIC), ③ the possibility of rapidly making a GaAs IC or a high electron mobility transistor (HEMT) IC on a substrate of large area, and ④ better heat radiation of a power device or a semiconductor laser because of the greater heat conductivity of Si than that of GaAs. However, the growth of GaAs is difficult by the ordinary method because there is lattice unconformity of 4% between Si and GaAs and these materials differ in coefficient of thermal expansion.

So, as methods of alleviating the lattice unconformity between Si and GaAs, there have been attempted a method of making GaAs/Ge/Si structure with Ge as an intermediate layer, a two-step growing method of cleaning an Si substrate at a high temperature, and thereafter growing amorphous thin GaAs at a low temperature, and increasing the temperature and growing GaAs at the ordinary growth temperature (that is, the structure is GaAs/low temperature GaAs/Si), a method of growing GaAs/AlGaAs super-lattice on Si and growing GaAs thereon (the structure is GaAs/GaAs-AlGaAs super-lattice/Si), and a method of making an intermediate layer into a strain super-lattice (GaAs/strain super-lattice/Si). Any of these growing methods uses MBE or organic metal chemical vapor phase deposition (MOCVD), and obtains single crystal of GaAs.

Various devices such as an FETs, solar cells and semiconductor lasers have been made on an experimental basis by the use of this GaAs grown on Si. It is also reported that although still inferior in characteristic to what has been grown on an GaAs substrate, a GaAs/AlGaAs double heterolaser has been made on an Si substrate and success has been won in oscillating it at room temperature.

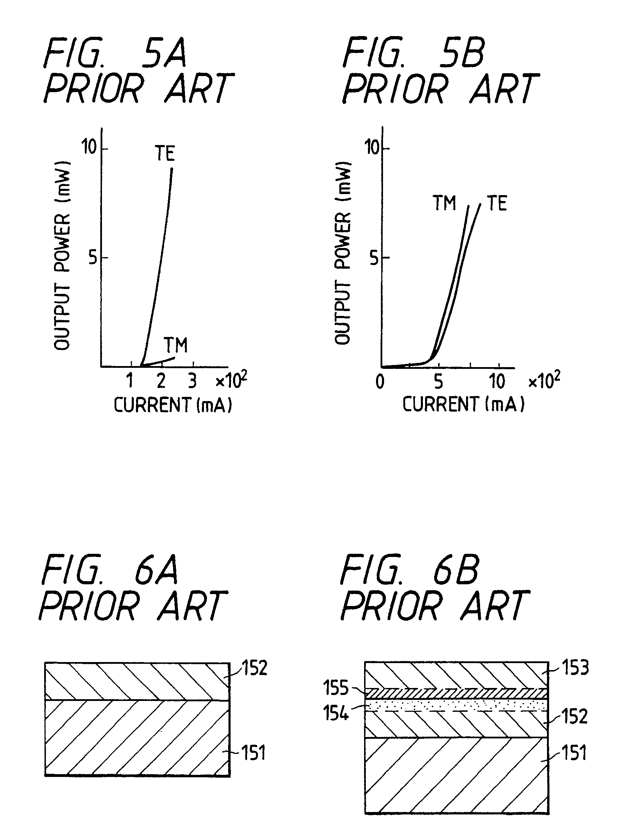

This example will hereinafter be described with reference to Figures 4, 5A and 5B of the accompanying drawings.

Figure 4 is a schematic perspective view showing another example of the prior-art semiconductor laser. In Figure 4, a normal pressure MOCVD apparatus was used and an n type Si substrate 171 of (100) 2° off was used to form a GaP layer 172 with a thickness of 0.1 $\mu$m on the Si substrate 171 at 900°C, and a GaP/GaAsP strain super-lattice (20 nm/20 nm x 5) 173 was formed at 750°C, and a GaAsP/GaAs strain super-lattice (20 nm/20 nm x 5) 173 was further formed, and on this super-lattice structure (SLS) 173, there were successively grown an n-GaAs layer 174 (having a thickness of 2 $\mu$m and impurity concentration of 2 x $10^{18}$ cm$^{-3}$), an n-Al$_x$Ga$_{1-x}$As layer 175 (having a thickness of 1.4 $\mu$m and impurity concentration of 1 x $10^{18}$ cm$^{-3}$) which is a lower clad layer, an undoped GaAs layer 176 (having a thickness of 0.08 $\mu$m) which is an active layer, a P-Al$_x$Ga$_{1-x}$As layer 177 (having a thickness of 1.4 $\mu$m and impurity concentration of 4 x $10^{17}$ cm$^{-3}$) which is an upper clad layer, and finally a P-GaAs layer 178 (having a thickness of 0.65 $\mu$m and impurity concentration of 1.3 x $10^{18}$ cm$^{-3}$). On this structure, an AuZn/Au layer 180 was deposited as an electrode on P side and an AuSb/Au layer 181 was deposited as an electrode on n side to make a laser of 10 $\mu$m wide stripe having a cavity length of about 300 $\mu$m.

Figure 5A shows the characteristic of a laser made on a GaAs substrate, and Figure 5B shows the characteristic of the laser made on the Si substrate as described above. It is seen that in the DH (double hetero) laser on GaAs, oscillation takes place only in the TE mode, while in the laser on Si, oscillation takes place in the TE + TM mode and the TM mode. This is considered to be attributable to the fact that Si and GaAs differ in coefficient of thermal expansion and therefore the GaAs layer grown on Si is subjected to a stress of about $10^9$ dyn/cm$^2$ and a light hole level and a heavy hole level have separated from each other.

In the thus improved laser made on the Si substrate, laser oscillation is achieved in a way, but such a semiconductor laser still suffers from the following problems:

(1) At present, a GaAs layer grown on an Si substrate has an etch pit of 1 x $10^6$ cm$^{-2}$, and this value should desirably be usually 1 x $10^3$ cm$^{-2}$ or less from the viewpoint of the life or the like of the laser; and

(2) A GaAs laser is a result of growth at a high temperature of 700°C and therefore, a great stress is created from the difference in coefficient of thermal expansion between Si and GaAs as described above, and in fact, the influence of it appears in the laser characteristic such as the TM mode oscillation.

Thus, the stress by the difference in lattice constant between Si and GaAs and the stress by the difference in coefficient of thermal expansion between Si and GaAs are not yet completely overcome, and the practical use of a semiconductor laser made on an Si substrate is considered to be difficult without the solution to the above-noted problems which greatly affect the life of the laser as well.

From this point of view, the technique of low-temperature growth of an optical device is important.

Next, making semiconductive materials complex is important to the optical communication technique and the display technique.

For example, from the requirement of flat panel display or the like, it has also been studied to integrate semiconductive materials corresponding to the three primary colors of light on one and the same substrate, and such materials include AlGaAs as red, GaP as yellow and ZnSe or the like as blue. A GaAs substrate may generally be mentioned as the substrate. Here, AlGaAs and GaP substantially coincide with GaAs in lattice constant, and light emitting diodes and semiconductor lasers using these materials have already been put into practical use. However, light emitting diodes and semiconductor lasers using ZnSe have not yet been put into practical use. This is because the doping of ZnSe is difficult and because the growth temperatures of ZnSe film and GaAs film differ greatly from each other. Generally, the optimum growth condition of ZnSe is 250°C - 350°C, whereas the optimum growth condition of GaAs is 500°C or higher.

So, in the example of the conventional growth, it is common to make ZnSe at 250°C - 350°C on a GaAs substrate, and if an attempt is made to grow GaAs film of good quality on ZnSe film, the mutual diffusion of Ga, As, Zn and Se will occur and pn junction will be formed on the interface between GaAs and ZnSe.

Figures 6A and 6B of the accompanying drawings show an example of this. In Figure 6A, an n-ZnSe layer 152 is grown on a substrate 151 of n-GaAs. The growth temperature at this time is 300°C. Subsequently, as shown in Figure 6B, an n type GaAs layer 153 is grown at a growth temperature of 500°C. Thereupon, Zn diffuses from the ZnSe layer 152 into the GaAs layer 153 with the result that some area 155 of the GaAs layer 153 becomes a P type GaAs area. Likewise, Ga diffuses from the GaAs layer 153 into the ZnSe layer 152 and an n area indicated by 154 is formed in the ZnSe layer 152. As a result, npn junction is formed between the substrate 151 and the GaAs layer 153.

Thus, there is always formed a device having a diode characteristic in the other portions than the junction of n-ZnSe and P-GaAs, and this forms a hindrance to the realization of a ZnSe device.

Also, to make a light emitting device of good efficiency, a material differing in band gap from ZnSe is necessary and it is further necessary that the lattice constant coincide with this, and GaAs and AlGaAs groups are considered to be appropriate as materials matching such conditions.

Like this, the demand for the realization of a ZnSe device is strong, but for this purpose, it is necessary to establish a technique of low-temperature growth free of mutual diffusion. If this is realized, a light emitting device including a ZnSe layer and the integration of GaAs, ZnSe, GaP, etc. can be achieved and further, this will provide an important technique of growth of crystal of II-VI group which is generally low in growth temperature.

From such a point of view as well, the technique of low-temperature growth of an optical device or the like becomes important.

SUMMARY OF THE INVENTION

It is an object of the present invention to solve the above-noted problems peculiar to the prior art and to provide a semiconductor device having crystal of good quality and excellent in characteristic, and a method of making the same.

The above object of the present invention is achieved by a semiconductor device which comprises a plurality of semiconductor layers formed on a substrate and including an active layer and formed of one of GaAs and AlGaAs and in which a GaAs layer having a thickness exceeding 500 Å is not interposed between the substrate and the active layer.

A semiconductor laser which is an embodiment of the present invention comprises:
a substrate;
a buffer layer formed on said substrate and formed of AlGaAs;
a first clad layer formed on said buffer layer and formed of AlGaAs;
a first light confining layer formed on said first clad layer and formed of AlGaAs;
an active layer formed on said first light confining layer;
a second light confining layer formed on said active layer;
a second clad layer formed on said second light confining layer; and
an electrode for letting an electric current flow to said active layer.

Also, a high electron mobility transistor which is another embodiment of the present invention comprises:
a substrate;
a buffer layer formed on said substrate and formed of AlGaAs;
an active layer formed on said buffer layer;
a doped layer formed on said active layer and formed of a semiconductor doped with impurities, a two-dimensional electron gas layer being formed on the interface between said doped layer and said active layer; and
source, gate and drain electrodes formed on said doped layer.

Also, a method of making the semiconductor device according to the present invention as described above comprises the steps of:
setting the temperature of said substrate to 500°C or lower and growing on said substrate a semiconductor layer formed of AlGaAs; and
setting the temperature of said substrate to 500°C or lower and growing an active layer on said AlGaAs layer without interposing a GaAs layer having a thickness exceeding 500 Å between said substrate and said AlGaAs layer.

BRIEF DESCRIPTION OF THE DRAWINGS

Figure 1 is a schematic cross-sectional view showing an example of the semiconductor laser according to the prior art.

Figure 2 is a graph showing the relation between the temperature of a substrate when the semiconductor laser of Figure 1 is made and the threshold value current of the laser made.

Figure 3 is a graph showing the density distribution of a donor when Sn is diffused in a GaAs layer.

Figure 4 is a schematic perspective view showing another example of the semiconductor laser according to the prior art.

Figure 5A is a graph showing the current-output characteristic of a prior-art semiconductor laser using a GaAs substrate.

Figure 5B is a graph showing the current-output characteristic of a prior-art semiconductor laser using an Si substrate.

Figure 6A is a schematic cross-sectional view showing an example in which an n type ZnSe layer was grown on an n type GaAs substrate.

Figure 6B is a schematic cross-sectional view showing an example in which an n type GaAs layer was further grown on the ZnSe layer of Figure 6.

Figure 7 is a schematic cross-sectional view showing a semiconductor laser which is a first embodiment of the present invention.

Figure 8 is a graph showing the relation between the temperature of a substrate and the intensity of the luminescence of each layer when a GaAs layer and an AlGaAs layer were grown on the substrate.

Figure 9 is a graph showing the relation between the temperature of a substrate and threshold value current density when a semiconductor laser having an AlGaAs buffer layer is made.

Figure 10 is a schematic cross-sectional view showing a semiconductor laser which is a second embodiment of the present invention.

Figure 11 illustrates the multiplex quantum well structure of the semiconductor laser of Figure 10.

Figure 12 is a schematic cross-sectional view showing a high electron mobility transistor which is a third embodiment of the present invention.

Figure 13 is a schematic cross-sectional view showing an example in which a GaAs:Si layer was grown on an Si substrate.

Figure 14 is a schematic cross-sectional view showing a semiconductor laser which is a fourth embodiment of the present invention.

Figure 15 is a graph showing the relation between the temperature of a substrate and threshold value current density when a semiconductor laser having a buffer layer formed of GaAs or AlGaAs is made.

Figure 16 is a schematic cross-sectional view showing a semiconductor laser which is a seventh embodiment of the present invention.

Figure 17 is a graph showing the result of the X-ray diffraction measurement of an AlGaAs layer of periodic structure.

Figure 18 is a graph showing the relation between the calibrated temperature of a molecular beam epitaxy device and the indication temperature of a thermocouple.

DESCRIPTION OF THE PREFERRED EMBODIMENTS

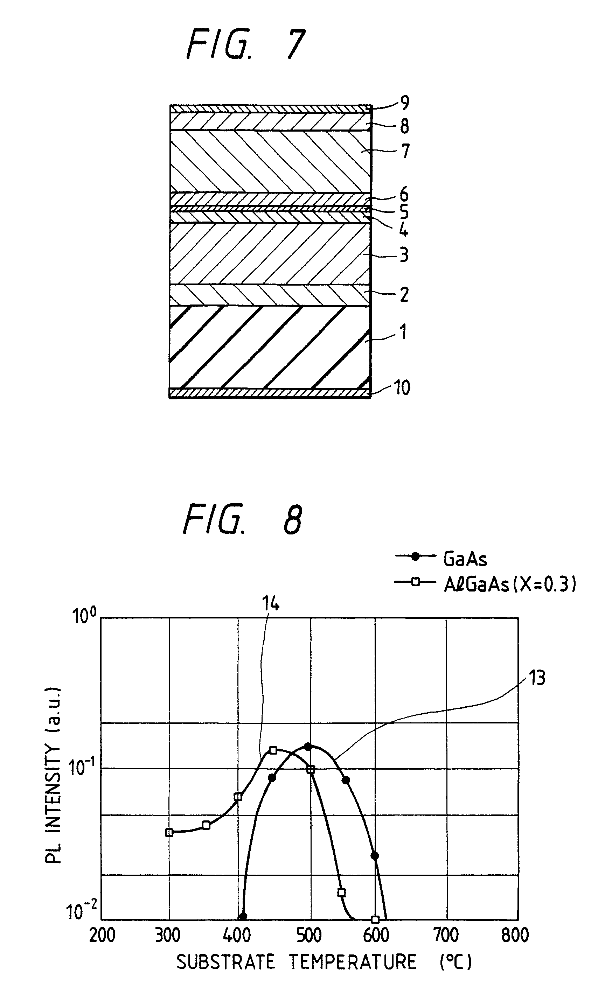

Figure 7 is a schematic cross-sectional view showing a semiconductor laser which is a first embodiment of the present invention. In this embodiment, an $Al_{0.2}Ga_{0.8}As$ layer is used in place of the GaAs layer 202 which is the buffer layer according to the prior art.

Before describing the present embodiment, Figure 8 will be described. Figure 8 shows the substrate temperature dependency of the intensity of photoluminescence (PL) at 77K of undoped GaAs and $Al_{0.3}Ga_{0.7}As$ made at a low growth temperature made by the BBE method. The ordinate represents the intensity of photoluminescence, and the abscissa represents the temperature of a substrate. Film of GaAs is greatest in the intensity of photoluminescence for the vicinity of 500°C as indicated by 13, and $Al_{0.3}Ga_{0.7}As$ is greatest in the intensity of photoluminescence for the vicinity of 450°C as indicated by 14. As the temperature becomes lower, the intensity of photoluminescence of GaAs sharply drops at 450°C or lower and GaAs does not shine at 400°C. In contrast, $Al_{0.3}Ga_{0.7}As$ does not sharply drop in the intensity of photoluminescence even if the temperature becomes 450°C or lower, and maintains the order of 1/3 of the intensity at 500°C even if the temperature becomes 300°C.

That is, it is seen that when low temperature growth takes place, the film of AlGaAs is better in quality.

The construction of the semiconductor laser of Figure 7 will be described here. In Figure 7, the reference numeral 1 designates an n-GaAs substrate, the reference numeral 2 denotes an n type buffer layer comprising Si-doped $Al_{0.2}Ga_{0.8}As$ having a thickness of 0.5 μm, the reference numeral 3 designates a clad layer comprising Si-doped $Al_{0.5}Ga_{0.5}As$ having a thickness of 1.5 μm, the reference numeral 4 denotes an undoped

$Al_YGa_{1-Y}As$ layer ($Y = 0.5 \rightarrow 0.3$) which is a graded light confining layer having a thickness of 500 Å, the reference numeral 5 designates a single quantum well (SQW) layer of GaAs which is an active layer having a thickness of 100 Å, the reference numeral 6 denotes an undoped $Al_YGa_{1-Y}As$ layer ($Y = 0.3 \rightarrow 0.5$) which is a graded upper light confining layer having a thickness of 500 Å, the reference numeral 7 designates a Be-doped $Al_{0.4}Ga_{0.6}As$ layer which is a p type clad layer having a thickness of 1.5 $\mu$m, the reference numeral 8 denotes a Be-doped GaAs layer which is a p type cap layer having a thickness of 5 $\mu$m, the reference numeral 9 designates an AuCr/Au layer which is a p side electrode, and the reference numeral 10 denotes an AuGe/Ni/Au layer which is an n side electrode. This laser was grown at a substrate temperature of 350°C and the growth temperature 0.7 $\mu$m/h of GaAs. The active layer 5 has a laser resonance cavity.

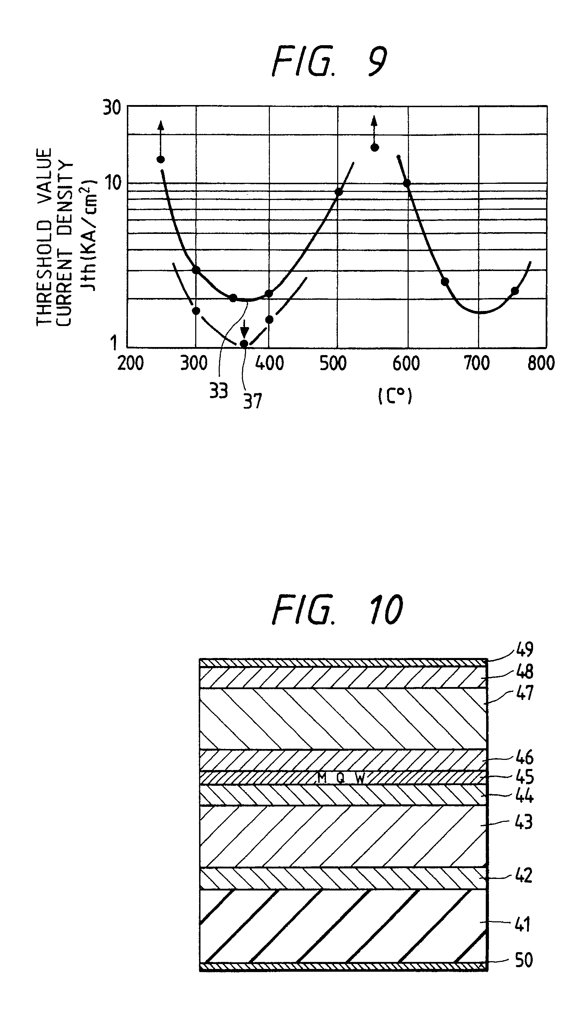

The relation between the threshold value current density of the semiconductor laser having the $Al_{0.2}Ga_{0.8}As$ buffer layer thus made and the temperature of the substrate is shown at 37 in Figure 9. It is seen that as compared with the low temperature side minimum value 33 of the example in which the GaAs buffer layer is inserted, Jth of the first embodiment is 1/2 and the AlGaAs buffer layer 2 works effectively.

The reason why the example in which the AlGaAs buffer layer is inserted is lower in Jth is considered to be that at low temperatures (500°C or lower), AlGaAs is better in quality of crystal than GaAs and is particularly excellent in flatness.

Accordingly, in low-temperature growth, the GaAs layer should preferably be made as thin as possible or be eliminated to improve flatness.

However, where the GaAs layer is a super-lattice having a thickness of 500 Å, it does not affect the characteristic of a device such as a laser. This is apparent from the heretofore made report that the periodic structure of a super-lattice, for example, GaAs/AlGaAs, improves the characteristic of a laser.

Thus, if the thickness of one layer is 500 Å or less, a plurality of GaAs layers may be included even where low-temperature growth is done.

The purity of GaAs of 500 Å or less will now be described. If GaAs is pure, there will be no problem, but actually, GaAs sometimes contain more or less impurities such as Al and In. To realize the above-described effect (the improvement in the characteristic in low-temperature growth), these impurities must be limited, but the limit of impurities may be 0.1% or less as composition. However, the dopant which determines the n or p type conductivity is outside this limiting range. The purity of GaAs also applies to the following embodiments.

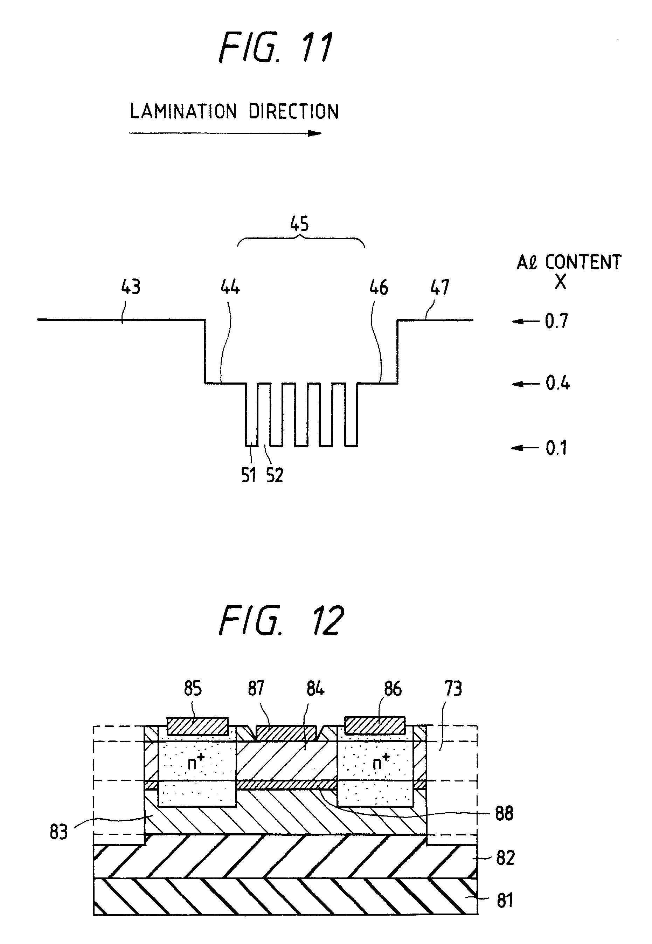

Figure 10 is a schematic cross-sectional view of a semiconductor laser which is a second embodiment of the present invention. In this embodiment, an active layer is of multiplex quantum well (MQW) structure. In Figure 10, the reference numeral 41 designates a p-GaAs substrate, the reference numeral 42 denotes a Be-doped $Al_{0.1}Ga_{0.9}As$ layer which is a p type buffer layer having a thickness of 1.0 $\mu$m, the reference numeral 43 designates a Be-doped $Al_{0.7}Ga_{0.3}As$ layer which is a p type clad layer having a thickness of 1.5 $\mu$m, the reference numeral 44 denotes a Be-doped $Al_{0.3}Ga_{0.7}As$ layer (in which carrier concentration is $5 \times 10^{17}$ cm$^{-3}$) which is a p type light confining layer having a thickness of 2000 Å, and the reference numeral 45 designates an MQW layer which is an active layer. The construction of the MQW layer 45 is shown in Figure 11. An undoped $Al_{0.1}Ga_{0.9}As$ layer 51 having a thickness of 80 Å is first formed as a well layer on the light confining layer 44, and an undoped $Al_{0.3}Ga_{0.7}As$ layer having a thickness of 100 Å is next formed as a barrier layer. Such layers 51 and 52 are alternately laminated and an Si-doped $Al_{0.3}Ga_{0.7}As$ layer 46 which is an n type upper light confining layer is grown to 2000 Å on the fifth well layer 51. Here, the carrier concentration of the layer 46 is $5 \times 10^{17}$ cm$^{-3}$. The upper arrow in Figure 11 indicates the lamination direction, and the numbers on the right side of Figure 11 indicate Al contents corresponding to band energy levels.

Turning back to Figure 10, an Si-doped $Al_{0.7}Ga_{0.3}As$ layer 47 which is an n type upper clad layer is further formed to a thickness of 1.5 $\mu$m on the upper light confining layer 46. Here, the carrier concentration of this layer 47 is $1 \times 10^{18}$ cm$^{-3}$. An Si-doped GaAs layer 48 which is an n type cap layer is formed to a thickness of 0.5 $\mu$m on the layer 47 to provide laser structure. The reference numeral 49 designates an Au (5000 Å)/Cr (500 Å) layer which is an n type electrode, and the reference numeral 50 denotes an Au (5000 Å)/AuGe (2000 Å) layer which is a p type electrode. The electrodes 49 and 50 are deposited by evaporation and heat-treated.

Again in this construction, as shown in Figure 9, there were two minimum points in the laser threshold value current density and the temperature of the substrate were in the vicinity of 350°C and 700°C. There was seen an improvement (a reduction) of about 20% in the threshold value current density of laser oscillation, as compared with the case where GaAs is contained in the layers lower than the active layer.

It will be more effective if a super-lattice layer comprising a GaAs layer (150 Å) and an $Al_{0.1}Ga_{0.9}As$ layer alternately laminated over five periods is included between the buffer layer 42 of Be-doped $Al_{0.1}Ga_{0.9}As$ and the clad layer 43 of Be-doped $Al_{0.1}Ga_{0.9}As$.

Again from the second embodiment, it is seen that where it is desired to obtain crystal of good quality at a low temperature (500°C or lower), it is better use an AlGaAs buffer layer than to use a GaAs buffer layer.

Figure 12 illustrates a third embodiment of the present invention. In Figure 12 which shows the contruction of HEMT, the reference numeral 81 designates a semi-insulative GaAs substrate, the reference numeral 82 denotes an undoped $Al_{0.5}Ga_{0.5}As$ layer which is a buffer layer having a thickness of 1.5 $\mu$m, the reference numeral 83 designates an undoped GaAs layer which provides an active layer area having a thickness of 1 $\mu$m, the reference numeral 84 denotes an Si-doped $Al_{0.2}Ga_{0.8}As$ layer having a thickness of 0.5 $\mu$m, the reference numeral 85 designates a source electrode, the reference numeral 86 denotes a gate electrode, the reference numeral 87 designates a drain electrode, and the reference numeral 89 denotes isolation.

A two-dimensional electron gas 88 is formed on the interface between the layer 83 and the layer 84 to provide a movable layer.

Usually, the layer 82 is formed of GaAs, but the present embodiment is in a form wherein nothing other than the AlGaAs layer makes epitaxial growth under the GaAs layer 83 which provides an active area. As a result, a transistor of excellent characteristic could be made by the growth at as low a temperature as 300°C.

The effect of the AlGaAs buffer layer is greater in an inverted HEMT type transistor. The inverted HEMT is a device in which there is an AlGaAs-doped layer on the substrate side and a two-dimensional electron gas is formed by the utilization of the interface thereof with an undoped GaAs layer grown thereon. This device is described in detail, for example, in Cirillo, N.C., et al.: IEEE Electron Device Lett. EDL-7: 71, 1986.

In this manner, the device characteristic at low temperatures was improved by causing a layer in which the thickness of GaAs exceeds 500 Å not to be included in any layer lower than the active area (which, in a laser, is an active layer, and in FET or the like, is a layer in which a carrier gathers, or a layer in which a channel is formed, and is used herein in this sense).

In the above-described embodiments, each device was made by the MBE method. The growth speed of GaAs was 0.7 $\mu$m/h, the range of the vapor pressure of As was 0.7 x $10^{-5}$ to 5 x $10^{-5}$ Torr, and the rotational speed of the substrate was 12 rpm (in the following embodiments as well, the MBE method is substantially under these conditions). The supply of the raw materials was effected continuously, and Ga, As, Al, etc. are not alternately supplied as in the migration-enhanced epitaxy (MEE) method. The MEE method is described in detail, for example, in Japanese Journal of Applied Physics, Vol. 28, No. 2, February, 1989, pp. 200-209, etc.

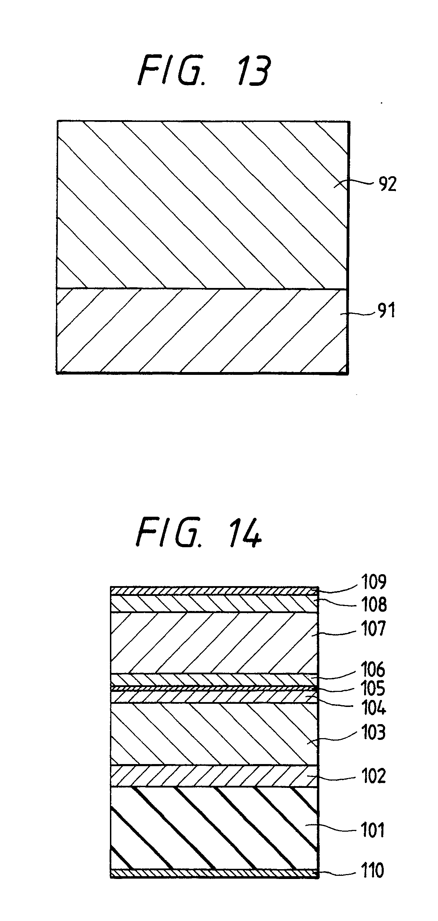

Now, the principle of the low-temperature growth (500°C or lower) by the above-described embodiments can also be applied to a case where a laser of AlGaAs line is to be made on an Si substrate. Figure 13 shows an example in which a GaAs: Si layer 92 was grown at a substrate temperature of 350°C on an Si substrate 91, and the defect density of the GaAs:Si layer 92 was 1 x $10^5$ $cm^{-3}$. In this example, an improvement of two or more figures was achieved as compared with the conventional method, and this is because the alleviation of the stress by the difference in coefficient of thermal expansion or the like could be achieved.

If the layer 92 was AlGaAs:Si, the defect density was further improved to 1 x $10^4$ $cm^{-3}$. It is seen from this result that in the low temperature range, a greater reduction in the defect density can be achieved in AlGaAs.

So, in a fourth embodiment which will hereinafter be described, an AlGaAs layer low in defect density is used as the buffer layer and design is made such that GaAs is not contained as much as possible in the layers lower than the active area. However, a single layer in which the thickness of GaAs is 500 Å or less and a super-lattice may be included as described above.

The present invention combines the effect of the AlGaAs buffer layer with the low-temperature growth technique (the technique of making a device containing $Al_xGa_{1-x}As$ in which x = 3.5 or x > 3.5 at 500°C or lower growth temperature) to thereby achieve an improvement in the device in the low-temperature growth. With regard to the purity of a GaAs layer having a thickness of 500 Å or less, what has been previously described need be noted.

Figure 14 shows a fourth embodiment in which a semiconductor laser was made on an Si substrate by the use of this principle. In order to realize low-temperature growth, the Al content in the clad layer is 0.5. In Figure 14, the reference numeral 101 designates an n type Si substrate having a (001) surface and which is off by 4° in <110> direction, the reference numeral 102 denotes an n type buffer layer formed of Si-doped $Al_{0.1}Ga_{0.9}As$ having a thickness of 0.5 $\mu$m, the reference numeral 103 designates an n type clad layer formed of Si-doped $Al_{0.5}Ga_{0.5}As$ having a thickness of 2.0 $\mu$m, and the reference numeral 104 denotes an n type light confining layer formed of Si-doped $Al_xGa_{1-x}As$ having a thickness of 1000 Å. Here, x is gradually reduced from 0.5 to 0.3.

The reference numeral 105 designates an active layer formed of undoped GaAs having a thickness of 100 Å, and the reference numeral 106 denotes a p type upper light confining layer formed of Be-doped $Al_yGa_{1-y}As$ having a thickness of 1000 Å. Here, y is gradually increased from 0.3 to 0.5. The reference numeral 107 designates a p type upper clad layer formed of Be-doped $Al_{0.5}Ga_{0.5}As$ having a thickness of 1.5 μm, the reference numeral 108 denotes a p type cap layer formed of Be-doped GaAs having a thickness of 0.5 μm, the reference numeral 109 designates a p type electrode, and the reference numeral 110 denotes an n type electrode.

The MBE method is used as the growing method, the growth speed of the GaAs layer 105 is 0.7 μm/h, the As pressure is $1 \times 10^{-5}$ Torr, the substrate temperature is 350°C and the rotational speed of the substrate is 12 rpm. Thereby, a threshold value current density 1.5 $KA/cm^2$ was achieved. In the present embodiment, as compared with the embodiments using GaAs, the threshold value current density is improved by 20 to 30%.

Thus, again in a case where an Si substrate is used, as in the above-described and following embodiments, a layer containing AlGaas having an Al content of 0.35 or more (for example, the layer 103 in the fourth embodiment) is grown at least under the active layer (formed of GaAs or AlGaAs) and a GaAs layer having a thickness exceeding 500 Å is not included under the active area or GaAs is eliminated, whereby film of very good crystalline property can be formed at a low temperature of 500°C or lower. The reason why such a growth temperature is employed is from the viewpoint of making OEIC because the temperature at which the electronic device is made is about of this degree, and from the viewpoint of the temperature range in which the influence of impurity diffusion temperature upon the device becomes small.

Again in an embodiment using an Si substrate, the structure of the active layer is not limited to the SQW as described above, but may be bulk type GaAs having a thickness of the order of 0.1 μm which does not have the MQW structure or the quantum effect.

Also for the HEMT of the third embodiment, a similar effect can be achieved with the substrate as semi-insulative Si. That is, an FET very excellent in characteristic was obtained by using an undoped $Al_{0.4}Ga_{0.6}As$ layer which is a buffer layer of composition suitable for low-temperature growth. Basically, this is of the same structure as Figure 12 and therefore will hereinafter be described with reference to Figure 12. In this fifth embodiment, the substrate 81 is a semi-insulative Si substrate, the layer 82 is an undoped $Al_{0.4}Ga_{0.6}As$ buffer layer having a thickness of 1.5 μm, the layer 83 is an undoped GaAs layer having a thickness of 1.0 μm, and the layer 84 is an Si-doped $Al_{0.2}Ga_{0.8}As$ layer having a thickness of 0.3 μm. Also, a source electrode 85, a drain electrode 86 and a gate electrode 87 are provided by the diffusion of Si, and a two-dimensional electron gas 88 is formed in the GaAs layer 83 of high purity.

The effect of this AlGaAs buffer is still greater for the reverse type HEMT.

This can of course also be applied to structure having the MQW layer of Figure 10. This sixth embodiment will hereinafter be described with reference to Figure 10. The reference numeral 41 designates a p type Si substrate, on which each layer is formed at a substrate temperature of 380°C. The reference numeral 42 denotes a Be-doped $Al_{0.2}Ga_{0.8}As$ layer which is a p type buffer layer having a thickness of 0.5 μm. The reference numeral 43 designates a Be-doped $Al_{0.5}Ga_{0.5}As$ layer which is a p type clad layer having a thickness of 1.5 μm. The reference numeral 44 denotes a Be-doped $Al_{0.3}Ga_{0.7}As$ layer which is a p type light confining layer having a film thickness of 1000 Å. The reference numeral 45 designates an MQW layer in which five well layers each having a thickness of 80 Å and formed of undoped $Al_{0.1}Ga_{0.9}As$ and four barrier layers each having a thickness of 100 Å and formed of undoped $Al_{0.3}Ga_{0.7}As$ are alternately laminated. This MQW layer is entirely the same as that of the second embodiment. The reference numeral 46 denotes an Si-doped $Al_{0.3}Ga_{0.7}As$ layer which is an n type upper light confining layer having a thickness of 1000 Å. The reference numeral 47 designates an Si-doped $Al_{0.5}Ga_{0.5}As$ layer which is an n type upper clad layer having a thickness of 1.5 μm. The reference numeral 48 denotes an Si-doped GaAs layer which is an n type cap layer having a thickness of 0.5 μm. The reference numeral 49 designates an n type electrode formed of AuGe/Ni/Au, and the reference numeral 50 denotes a p type electrode. The $Al_{0.2}Ga_{0.8}As$ buffer layer 42 includes super-lattice structure in which each five sets of GaAs layers (150 Å) and $Al_{0.2}Ga_{0.8}As$ layers (150 Å) are alternately laminated.

Again in the laser of such construction, the effect of the AlGaAs buffer layer is displayed and Jth = 3 $KA/cm^2$ is achieved.

Further, the MBE method is used in the above-described embodiments, but by crystal-growing parts of the semiconductor device (AlGaAs and GaAs crystals) by the MEE method, the crystalline property at lower temperatures can be improved.

For example, in the first embodiment, the light confining layers 4 and 6 and the GaAs active layer 5 are grown by the MEE method. In this case, it is best to grow the layers above the buffer layer by the MEE method, but if the raw materials Al, Ga and As are alternately supplied, the time required will become several times longer and therefore, in the embodiment, parts of the device, i.e., only the buffer layer and the clad layer are formed by the MEE method.

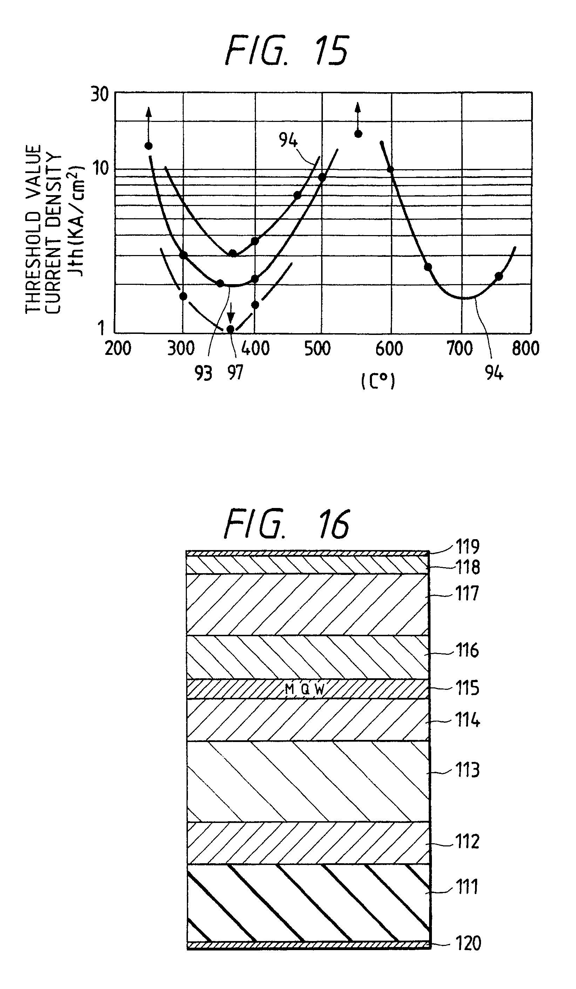

Figure 15 shows the effect of providing the AlGaAs buffer layer and the effect of the MEE method. In Figure 15, the reference numeral 94 shows the growth temperature dependency of Jth when the GaAs buffer layer is provided, the reference numeral 93 shows the state of general reduction in Jth when the buffer layer is formed of $Al_{0.2}Ga_{0.8}As$, and the reference numeral 97 shows the reduction in Jth when the light confining layers and the active layer are made by the MEE method. By the use of the MEE method and the effect of the AlGaAs buffer layer, the minimum point of the threshold value current density Jth in the vicinity of the grow temperature 350° C became about 1/3 of that in the case shown by 94 where the GaAs buffer layer was used.

Description will now be made of a case where the MEE method was applied to the upper portion 2000 Å of the buffer layer 42 and the light confining layers 44, 46 and the active layer (MQW) 45 in the second embodiment. Here, Ga and Al formed a pair and were applied alternately with As. Si as the dopant was applied substantially simultaneously with the application of As. In the case of the Gaas layer present in the upper super-lattice of the buffer layer 42, Ga and Al are alternately applied.

Again in this case, by the effect of the use of the AlGaAs buffer layer and the MEE method, Jth was improved by about 30% as compared with a case where a GaAs buffer layer is provided and the MEE method is not used.

The combination of the MEE method and the low-temperature growth using the AlGaAs layer can also be applied to the third embodiment of Figure 12. Here, the area using the MEE method is a GaAs layer 83 of high purity. Of course, this combination can also be more effectively applied to a reverse HEMT type transistor.

The combination of the MEE method and the low-temperature growth using the AlGaAs buffer layer can also be applied to an example having an Si substrate. In the fourth embodiment of Figure 14, the upper portion 2000 Å of the clad layer 103, the light confining layers 104 and 106 and the active layer 105 were grown by the MEE method. The other portions were grown by the low-temperature MBE method using the AlGaAs buffer layer. The growth temperature was constant, i.e., 350° C.

The threshold value current density of the semiconductor laser made thereby was 1.5 kA/cm², and was improved by 20 - 30% as compared with the case where the GaAs buffer layer was used.

The combination of the MEE method and the low-temperature MBE method can also be applied to an example using an Si substrate and the sixth embodiment having the MQW active layer as well as an example having a bulk type GaAs active layer.

Wherein the sixth embodiment, the light confining layers and the active layer were grown by the MEE method and the other portions were formed by the low-temperature MBE method using the AlGaAs buffer layer, the threshold value current density Jth was 1.5 KA/cm².

Also, where in the fifth embodiment of HEMT, a part of the laminated layers and the other part of the laminated layers were made at a constant growth temperature 400° C by the MEE method and the MBE method, respectively, there was obtained an FET very excellent in characteristic.

By the MEE method and the low-temperature MBE method which uses the AlGaAs buffer being thus also used in the example using an Si substrate, the stress by the difference in coefficient of thermal expansion could be further reduced and a device using GaAs and AlGaAs and excellent at low temperatures which were heretofore not experienced could be formed on the Si substrate.

Description will now be made of an embodiment in which the principle of the present invention is applied to a device containing in laminated layers ZnSe or the like for which is desired low-temperature growth free of mutual diffusion.

Figure 16 shows a schematic cross-sectional view of a semiconductor laser according to a seventh embodiment. The device of this figure is a ZnSe-GaAs super-lattice laser made at a growth temperature of 300° C. The reference numeral 111 designates an n type GaAs substrate, the reference numeral 112 denotes an n type buffer layer formed of Si-doped GaAs having a thickness of 0.5 μm, the reference numeral 113 designates an n type clad layer formed of Si-doped $Al_{0.5}Ga_{0.5}As$ (in which carrier concentration is $8 \times 10^{17}$ cm$^{-3}$) having a thickness of 5 μm, the reference numeral 114 denotes an n type clad layer formed of Ga-doped ZnSe (in which carrier concentration is $1 \times 10^{18}$ cm$^{-3}$) having a thickness of 0.5 μm, and the reference numeral 115 designates an MQW active layer. The construction of the active layer 115 comprises five undoped $Al_{0.3}Ga_{0.7}As$ layers each having a thickness of 60 Å as well layers and four undoped ZnSe layers each having a thickness of 100 Å as barrier layers, the well layers and the barrier layers being alternately laminated. On this active layer 115, an Li, N-doped ZnSe layer 116 which is a p type upper clad layer is grown to a thickness of 0.5 μm, and a Be-doped $Al_{0.5}Ga_{0.5}As$ layer 117 which also is a p type upper clad layer is grown to a thickness of 1.0 μm. The reference numeral 118 designates a Be-doped GaAs layer which is a p type cap layer, the reference numeral 119 denotes an Au/Cr layer which is a p type electrode, and the reference numeral 120 designates an AuGe/Ni/Au layer which is an n type electrode.

It has been found that the semiconductor laser thus made exhibits a good I (current) - V (voltage) characteristic and has no mutual diffusion layer formed therein.

Also, when n type laminated layers similar to those of Figure 6B were made by low-temperature growth and the electrode were eliminated, the I-V characteristic obtained exhibited a fine ohmic characteristic. If in this example, the growth temperature is 500°C or lower, the influence of the mutual diffusion layer can be neglected.

Thus, if a laser device of AlGaAs line can be grown at low temperatures, a low-temperature grown device including ZnSe, ZnSeS and ZnTe can be integrated. As a result, the integration of materials such as ZnSe, AlGaAs, InGaP and GaP becomes possible and active flat panel display or the like can be put into practical use.

The integration with an FET of GaAs line also becomes possible by low-temperature growth. Further, the compounding with the II-VI group has been chiefly described herein, but this low-temperature growth technique is indispensable for the compounding with materials which require low-temperature growth, and can also be applied to other materials GaP, InGaP, etc.

Further, the combination of the MEE method and the low-temperature MBE method using an AlGaAs buffer layer can also be applied to the seventh embodiment of Figure 16, whereby the film grown at a low temperature can be made higher in quality.

In the embodiment of Figure 16, the ZnSe layer 114 and 116 and the active layer 115 were laminated by the use of the MEE method. The other laminated portions than those laminated by the MEE method were laminated by the MBE method. It is seen that as compared with the I-V characteristic which does not use the MEE method, the characteristic of this embodiment becomes better in rising and the improvement in the crystallizing method using the MEE method has an effect. Of course, the area grown by the use of the MEE method is not restricted, but generally it is considered that the vicinity of the active layer of a semiconductor laser, an FET or the like is good.

Now, as the buffer layer for achieving the effect of the present invention, use need not always be made of mixed crystal $Al_xGa_{1-x}As$ as described above, but use may be made of a buffer layer of super-lattice structure such as $Al_xGa_{1-x}As/GaAs$, $Al_xGa_{1-x}AS/Al_yGa_{1-y}As$, AlAs/GaAs or AlAs/$Al_xGa_{1-x}As$ (but the film thickness of the Gaas layer does not exceed 500 Å).

Finally, description will be made of a method of judging the low-temperature growth in the MBE method.

When AlxGa₁-ₓAs is MBE-grown at a low temperature, there is formed periodic structure corresponding to the growth speed of AlGaAs and the rotation of the substrate. This is because the flaxes of Al and Ga are not uniformly applied to the surface of the substrate and has an intensity distribution in the surface. The flaxes of Al and Ga have their maximum intensity at discrete locations in the surface. Therefore, when $Al_xGa_{1-x}As$ is grown while the substrate is rotated, the composition of AlGaAs is modulated in the direction of growth and there is spirally formed a portion in which the intensity of Al is strong. The length of one period of this AlGaAs is 3.889 Å/sec. x 5 sec. = 19.445 Å when the growth speed of AlGaAs is 3.889 Å/sec. and the number of rotations is 12 rpm (one full rotation per 5 seconds).

Here, the average composition x of $Al_xGa_{1-x}As$ used in the experiment was 0.5. The growth temperature is 350°C.

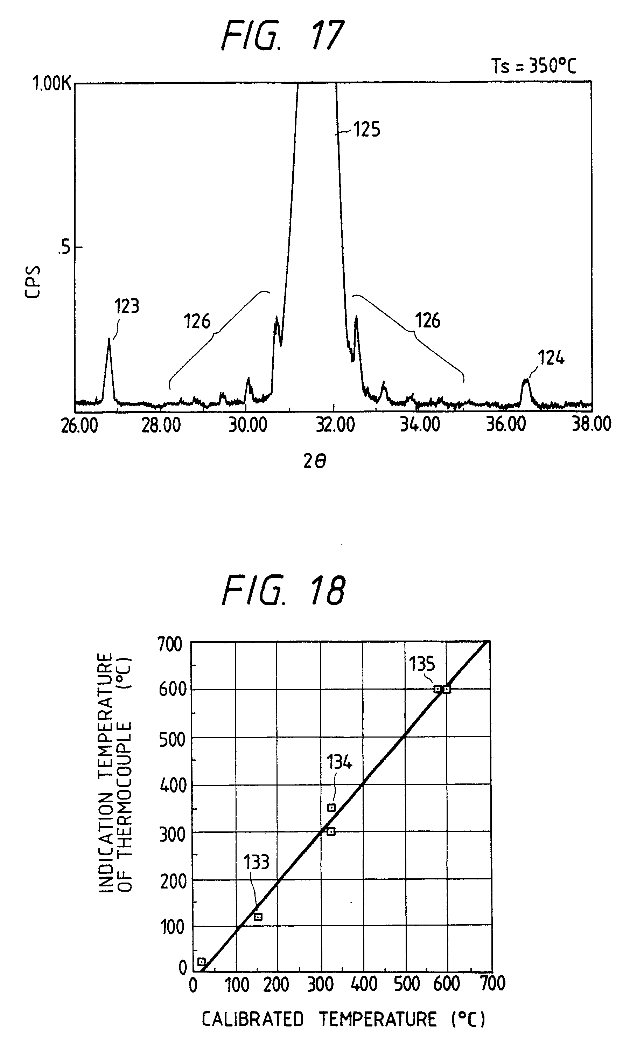

As a method of judging this periodic structure, there is a method of judging it by X-ray diffraction. Figure 17 shows the result of the X-ray diffraction measurement of film in which $Al_xGa_{1-x}As$ (x = 0.5) was formed to a thickness of 2 μm.

In Figure 17, the abscissa represents the angle of diffraction $2\theta$ and the ordinate represents X-ray count number (cps). The result will hereinafter be described. The reference numeral 125 designates the peak (200) from the unit lattice of $Al_xGa_{1-x}As$ (x = 0.5). The reference numerals 126 present on both sides of this peak denote super-lattice diffraction peaks observed from the five periods 150 Å of GaAs 150 Å/ $Al_xGa_{1-x}As$ (x = 0.5) inserted into the intermediate portion of $Al_xGa_{1-x}As$.

The reference numerals 123 and 124 present besides these represent periodic structure created by the flax irregularity of Al and Ga and the rotation period. When $\theta_0$ is the angle at which there appears reflection (200) corresponding to the average composition of AlGaAs and $\lambda$ is the wavelength of X-ray and $\Lambda$ is the period of the periodic structure and $\theta\pm$ is the deviation from the angle of reflection (200) corresponding to the average composition of AlGaAs of a satellite peak created by the periodic structure, there is established the following equation:

$$\Lambda = \lambda/\{2(\sin \theta \pm 1st\ order - \sin \theta_0)\},$$

where $\lambda$ = 1.54 Å, $\theta_0$ = 31.6°, $\theta$ + 1st order = 36.5° and $\theta$ -1st order = 26.82°, and therefore the period is 19.1 Å. This substantially coincides with the period 19.445 Å expected from the rotation period.

Such a phenomenon occurs because diffusion is little if the temperature is low. The present low-temperature growth technique can be judged with this phenomenon as a standard.

Further, the temperature calibration of an MBE apparatus will hereinafter be described. The calibration was carried out by the calibration by the melting points of indium (In) and lead (Pb) and the temperature for removing oxidized film on the surface of the GaAs substrate. In and Pb were caused to adhere onto the GaAs substrate, and temperature was measured with the substrate mounted on a non-In holder.

The result is shown in Figure 18. The ordinate represents the indication value of a thermocouple mounted on the MBE apparatus. The abscissa represents the temperatures of In and Pb and the temperature calibrated by the oxidized film removing temperature of GaAs. The reference numeral 133 indicates the temperature 157°C of indium (In), the reference numeral 134 indicates the temperature 328°C of lead (Pb), and the reference numeral 135 indicates the removing temperature for the oxidized film (580°C - 600°C) of GaAs. It is seen that in the MBE apparatus used, the indication value of the thermocouple and the growth temperature substantically coincide with each other.

As described above, according to the present invention, film of good quality and a device which does not include in an active area GaAs whose thickness exceeds 500 Å can be made at a growth temperature of 500°C or lower by the use of the MEE method or the MBE method.

Accordingly, mutual diffusion such as doping and stress by the difference in coefficient of thermal expansion can be reduced and an ideal device can be made by a process having a great degree of freedom.

Thus, the integration of a semiconductor laser, a field effect transistor, a detector, an optical wave guide or the like becomes possible by the present growing method, and an opto-electronic integrated circuit (OEIC) and an electronic integrated circuit (IC) can be made. Further, the application of the present invention to a three-dimensional integrated circuit will also become possible in the future. The OEIC and integrated circuits of compound semiconductors have the characteristic of high-speed operation, and have been studied as parts for optical communications, computers and measuring devices and have partially been put into practical use. The present crystal growth is an important method for achieving the improved reliability and reduced costs of these integrated circuits by the low-temperature growth technique which is indispensable for the integration of semiconductor devices. Also, the present invention has been developed in order that the present crystal growth may be practically used for OEIC or the like and may become a part of an optical communication system.

The present invention permits various applications thereof in addition to the above-described embodiments. For example, the present invention is not restricted to the semiconductor laser and high electron mobility transistor previously described, but can also be applied to ordinary FET and photo-detectors. The present invention covers all such application without departing from the scope thereof as defined in the appended claims.

This specification discloses a semiconductor device which comprises a plurality of semiconductor layers formed on a substrate and including an active layer and formed of one of GaAs and Al-GaAs and which does not have any GaAs layer having a thickness exceeding 500 Å between the substrate and the active layer. The specification also discloses a method of making a semiconductor device comprising a substrate and a plurality of semiconductor layers including an active layer formed on the substrate. The method comprises the steps of rendering the temperature of the substrate into 500°C or lower, and growing on the substrate a semiconductor layer formed of AlGaAs, and rendering the temperature of the substrate into 500°C or lower, and growing an active layer on the AlGaAs layer without interposing a GaAs layer having a thickness exceeding 500 Å between the substrate and the AlGaAs layer.

## Claims

1. A semiconductor device comprising a plurality of semiconductor layers formed on a substrate and including an active layer and formed of one of GaAs and AlGaAs, characterized in that said device does not have any GaAs layer having a thickness exceeding 500 Å between said substrate and said active layer.

2. A semiconductor device according to Claim 1 which comprises a semiconductor laser.

3. A semiconductor device according to Claim 1 which comprises a high electron mobility transistor.

4. A semiconductor laser comprising:
    a substrate;
    a buffer layer formed on said buffer layer and formed of AlGaAs;
    a first clad layer formed on said buffer layer and formed of AlGaAs;
    a first light confining layer formed on said first clad layer and formed of AlGaAs;

an active layer formed on said first light confining layer;

a second light confining layer formed on said active layer;

a second clad layer formed on second light confining layer; and

an electrode for letting an electric current flow to said active layer.

5. A semiconductor laser according to Claim 4, wherein said substrate, said buffer layer and said first clad layer each have one of n type and p type polarities, and said second clad layer has a polarity opposite to that of said first clad layer.

6. A semiconductor laser according to Claim 4, wherein said second light confining layer and said second clad layer are formed of AlGaAs.

7. A semiconductor laser according to Claim 4, wherein said substrate is formed of GaAs.

8. A semiconductor laser according to Claim 4, wherein said substrate is formed of Si.

9. A semiconductor laser according to Claim 4, wherein said active layer comprises a GaAs layer of single quantum well structure.

10. A semiconductor laser according to Claim 4, further comprising a cap layer formed on said second clad layer and formed of GaAs.

11. A semiconductor laser comprising:

a substrate formed of n type GaAs;

a buffer layer formed on said substrate and formed of AlGaAs doped with Si;

a first clad layer formed on said buffer layer and formed of AlGaAs doped with Si;

a first light confining layer formed on said first clad layer and formed of undoped AlGaAs;

an active layer formed on said first light confining layer and formed of an undoped semiconductor;

a second light confining layer formed on said active layer and formed of undoped AlGaAs;

a second clad layer formed on said second light confining layer and formed of AlGaAs doped with Be;

a p type electrode formed on said second clad layer; and

an n type electrode formed on the bottom surface of said substrate.

12. A semiconductor laser according to Claim 11, wherein said active layer comprises a GaAs layer of single quantum well structure.

13. A semiconductor laser according to Claim 11, further comprising a cap layer formed between said second clad layer and said p type electrode and formed of GaAs doped with Be.

14. A semiconductor laser comprising:

a substrate formed of p type GaAs;

a buffer layer formed on said substrate and formed of AlGaAs doped with Be;

a first clad layer formed on said buffer layer and formed of AlGaAs doped with Be;

a first light confining layer formed on said first clad layer and formed of AlGaAs doped with Be;

an active layer formed on said first light confining layer and formed of an undoped semiconductor;

a second light confining layer formed on said active layer and formed of AlGaAs doped with Si;

a second clad layer formed on said second light confining layer and formed of AlGaAs doped with Si;

an n type electrode formed on said second clad layer; and

a p type electrode formed on the bottom surface of said substrate.

15. A semiconductor laser according to Claim 14, wherein said active layer has multiplex quantum well structure in which a plurality of well layers and barrier layers are alternately laminated.

16. A semiconductor laser according to Claim 14, further comprising a cap layer formed between said second clad layer and said n type electrode and formed of GaAs doped with Si.

17. A semiconductor laser according to Claim 14, further comprising a super-lattice layer formed between said buffer layer and said first clad layer and in which GaAs layers and AlGaAs layers each having a thickness not exceeding 500 Å are alternately laminated.

18. A semiconductor laser comprising:

a substrate formed of n type Si;

a buffer layer formed on said substrate and formed of AlGaAs doped with Si;

a first clad layer formed on said buffer layer and formed of AlGaAs doped with Si;

a first light confining layer formed on said clad layer and formed of AlGaAs doped with Si;

an active layer formed on said first light confining layer and formed of an undoped semiconductor;

a second light confining layer formed on said active layer and formed of AlGaAs doped with Be;

a second clad layer formed on second light confining layer and formed of AlGaAs doped with Be;

a p type electrode formed on said second clad layer; and

an n type electrode formed on the bottom surface of said substrate.

19. A semiconductor laser according to Claim 18, wherein said active layer comprises an undoped GaAs layer.

20. A semiconductor laser according to Claim 18, further comprising a cap layer formed between said second clad layer and said p type electrode and formed of GaAs doped with Be.

21. A semiconductor laser comprising:
a substrate formed of p type Si;

a buffer layer formed on said substrate and formed of AlGaAs doped with Be;

a first clad layer formed on said buffer layer and formed of AlGaAs doped with Be;

a first light confining layer formed on said first clad layer and formed of AlGaAs doped with Be;

an active layer formed on said first light confining layer and formed of an undoped semiconductor;

a second light confining layer formed on said active layer and formed of AlGaAs doped with Si;

a second clad layer formed on said second light confining layer and formed of AlGaAs doped with Si;

an n type electrode formed on said second clad layer; and

a p type electrode formed on the bottom surface of said substrate.

22. A semiconductor laser according to Claim 21, wherein said active layer has multiplex quantum well structure in which a plurality of well layers and barrier layers are alternately laminated.

23. A semiconductor laser according to Claim 21, further comprising a cap layer formed between said second clad layer and said n type electrode and formed of GaAs doped with Si.

24. A semiconductor laser according to Claim 21, wherein said buffer layer includes a super-lattice layer in which GaAs layers and AlGaAs layers each having a thickness not exceeding 500 Å are alternately laminated.

25. A semiconductor laser comprising:
a substrate formed of n type GaAs;

a buffer layer formed on said substrate and formed of GaAs doped with Si and having a thickness of 500 Å or less;

a first clad layer formed on said buffer layer and formed of AlGaAs doped with Si;

a second clad layer formed on said first clad layer and formed of ZnSe doped with Ga;

an active layer formed on said second clad layer and formed of an undoped semiconductor;

a third clad layer formed on said active layer and formed of ZnSe doped with Li and N;

a fourth clad layer formed on said third clad layer and formed of AlGaAs doped with Be;

a p type electrode formed on said fourth clad layer; and

an n type electrode formed on the bottom surface of said substrate.

26. A semiconductor laser according to Claim 25, wherein said active layer has multiplex quantum well structure in which a plurality of well layers formed of undoped AlGaAs and a plurality of barrier layers formed of undoped ZnSe are alternately laminated.

27. A semiconductor laser according to Claim 25, further comprising a cap layer formed between said fourth clad layer and said p type electrode and formed of GaAs doped with Be.

28. A high electron mobility transistor comprising:
a substrate;

a buffer layer formed on said substrate and formed of AlGaAs;

an active layer formed on said buffer layer;

a doped layer formed on said active layer and formed of a semiconductor doped with impurities, a two-dimensional electron gas layer being formed between said doped layer and said active layer; and

source, gate and drain electrodes formed on said doped layer.

29. A high electron mobility transistor according to Claim 28, wherein said active layer is formed of undoped GaAs.

30. A high electron mobility transistor according to Claim 28, wherein said doped layer is formed of AlGaAs doped with Si.

**31.** A high electron mobility transistor according to Claim 28, wherein said substrate comprises a semi-insulative GaAs substrate.

**32.** A high electron mobility transistor according to Claim 28, wherein said substrate comprises a semi-insulative Si substrate.

**33.** A high electron mobility transistor according to Claim 28, wherein said buffer layer is formed of undoped AlGaAs.

**34.** A high electron mobility transistor comprising:
a substrate;
a doped layer formed on said substrate and formed of AlGaAs doped with impurities;
an active layer formed on said doped layer, a two-dimensional electron gas layer being formed on the interface between said active layer and said doped layer; and
source, gate and drain electrodes formed on said active layer.

**35.** A high electron mobility transistor according to Claim 34, wherein said active layer is formed of undoped GaAs.

**36.** A method of making a semiconductor device comprising a substrate and a plurality of semiconductor layers including an active layer formed on said substrate, comprising the steps of:
rendering the temperature of said substrate into $500^\circ$ C or lower, and growing on said substrate a semiconductor layer formed of AlGaAs; and
rendering the temperature of said substrate into $500^\circ$ C or lower, and growing an active layer on said AlGaAs layer without interposing a GaAs layer having a thickness exceeding 500 Å between said substrate and said AlGaAs layer.

**37.** A method of making a semiconductor laser comprising a substrate and a plurality of semiconductor layers including an active layer formed on said substrate, comprising the steps of:
rendering the temperature of said substrate into $500^\circ$ C or lower, and growing on said substrate a buffer layer formed of AlGaAs;
rendering the temperature of said substrate into $500^\circ$ C or lower, and growing on said buffer layer a first clad layer formed of AlGaAs;
rendering the temperature of said substrate into $500^\circ$ C or lower, and growing on said first clad layer a first light confining layer formed of AlGaAs;
rendering the temperature of said substrate into $500^\circ$ C or lower, and growing an active layer on said first light confining layer;
rendering the temperature of said substrate into $500^\circ$ C or lower, and growing a second light confining layer on said active layer;
rendering the temperature of said substrate into $500^\circ$ C or lower, and growing a second clad layer on said second light confining layer; and
forming an electrode for letting an electric current flow to said active layer.

**38.** A method according to Claim 37, wherein each of said semiconductor layers is grown by electron beam epitaxy.

**39.** A method according to Claim 37, wherein each of said semiconductor layers is grown by migration-enhanced epitaxy.

**40.** A method of making a high electron mobility transistor comprising a substrate, and a buffer layer, an active layer, a source electrode, a gate electrode and a drain electrode formed on said substrate, comprising the steps of:
rendering the temperature of said substrate into $500^\circ$ C or lower, and growing on said substrate a buffer layer formed of AlGaAs;
rendering the temperature of said substrate into $500^\circ$ C or lower, and growing an active layer on said buffer layer; and
forming a source electrode, a gate electrode and a drain electrode on said active layer.

**41.** A method according to Claim 40, further comprising the step of rendering the temperature of said substrate into $500^\circ$ C or lower, and growing a doped layer formed of a semiconductor doped with impurities between said active layer and each of said electrodes.

**42.** A method according to Claim 41, wherein said doped layer is formed of AlGaAs doped with Si.

**43.** A method according to Claim 40, wherein said active layer is formed of undoped GaAs.

**44.** A method according to Claim 40, wherein said substrate comprises a semi-insulative GaAs substrate.

**45.** A method according to Claim 40, wherein said substrate comprises a semi-insulative Si substrate.

46. A method according to Claim 40, wherein said buffer layer is formed of undoped AlGaAs.

47. A method according to Claim 40, wherein said buffer layer is formed of AlGaAs doped with impurities.

48. A method according to Claim 40, wherein each of said semiconductor layers is grown by electron beam epitaxy.

49. A method according to Claim 40, wherein each of said semiconductor layers is grown by migration-enhanced epitaxy.

EP 0 452 869 A1

# FIG. 1  PRIOR ART

207
206
205
204
203
202
201
8

# FIG. 2  PRIOR ART

GaAs DH

Jth (KA/cm²)

100

10

1

300  400  500  600  700  800  900

SUBSTRATE  TEMPERATURE  (°C)

16

# FIG. 3 PRIOR ART

- —·— 550°C
- – – – 580°C
- —— 615°C

DONOR CONCENTRATION ( /cm³)
DEPLETION DEPTH (MICRONS)

# FIG. 4 PRIOR ART

180
SiO₂ FILM
178
177
176
175
174
173
172
171
181

## FIG. 5A
## PRIOR ART

## FIG. 5B
## PRIOR ART

## FIG. 6A
## PRIOR ART

## FIG. 6B
## PRIOR ART

# FIG. 7

# FIG. 8

EP 0 452 869 A1

# FIG. 9

# FIG. 10

20

# FIG. 11

LAMINATION DIRECTION

Aℓ CONTENT
X

← 0.7

← 0.4

← 0.1

45

43    44    46    47

51  52

# FIG. 12

85    87    84    86    73

n⁺    n⁺

83

88

82

81

## FIG. 13

92
91

## FIG. 14

109
108
107
106
105
104
103
102
101
110

## FIG. 15

## FIG. 16

EP 0 452 869 A1

FIG. 17

FIG. 18

24

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 057 748  (MATSUSHITA)<br>* page 2, lines 31-48; figure 3 * | 1,2,4-27 | H 01 L 29/76<br>H 01 S 3/19<br>H 01 L 21/203 |
| Y | | 36-39 | |
| X | IEEE ELECTRON DEVICE LETTERS vol. EDL-2, no. 1, January 1981, pages 14,15, New York, US; S. JUDAPRAWIRA et al.: "Modulation-doped MBE GaAs/n-AlxGa1-xAs MESFETs"<br>* the whole document * | 1,3,28-35 | |
| Y | idem | 40-49 | |
| A | idem | 36 | |
| Y | JOURNAL OF CRYSTAL GROWTH vol. 95, nos. 1-4, February 1989, pages 391,392, Amsterdam, NL; T. MATSUNO et al.: "Growth and properties of N-AlGaAs/InGaAs selectively-doped single-and double-heterojunction fet structures"<br>* pages 391,392; figures 1,4,5 * | 36-49 | |
| X | PROCEEDINGS OF THE 13TH INTERNATIONAL SYMPOSIUM ON GALLIUM ARSENIDE AND RELATED COMPOUNDS 1 October 1986, pages 581-586, Bristol, GB; Y.K. CHEN et al.: "DC and RF characterization of a planar-doped double heterojunction MODFET"<br>* figure 1 * | 1,3,17 | TECHNICAL FIELDS SEARCHED (Int. Cl.5)<br><br>H 01 L<br>H 01 S |
| X | PATENT ABSTRACTS OF JAPAN vol. 10, no. 170 (E-412)(2226), 17 June 1986;<br>& JP - A - 61023364 (KOGYO GIJUTSUIN) 31.01.1986<br>* the whole document * | 1,3,34,35 | |

−/−

The present search report has been drawn up for all claims

| Place of search | Date of completion of search | Examiner |
|---|---|---|
| Berlin | 26 July 91 | MUNNIX S J G |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | JOURNAL OF VACUUM SCIENCE AND TECHNOLOGY: PART B vol. 2, no. 2, April-June 1984, pages 259-261, New York, US; T. FUJII et al.: "Very low threshold current GaAs-AlGaAs GRIN-SCH lasers grown by MBE for OEIC applications" <br> * the whole document * | 1,2,4-27 | |
| A | I.E.E.E. ELECTRON DEVICE LETTERS vol. EDL-7, no. 11, November 1986, pages 635-637, New York, US; D.K ARCH et al.: "High-Performance Self-Aligned Gate (Al,GA)As/GaAs MODFET's on MBE Layers Grown on (100) Silicon Substrates" <br> * the whole document * | 8,18-24, 32 | |
| A | PATENT ABSTRACTS OF JAPAN vol. 10, no. 16 (E-375)(2073), 22 January 1986; <br> & JP - A - 60178683 (NIPPON DENKI K.K.) 12.09.1985 <br> * the whole document * | 26 | |
| A | TECHNICAL DIGEST OF THE INTERNATIONAL ELECTRON DEVICES MEETING 1987 9 December 1987, pages 422-425, New York, US; K. INOUE et al.: "Strained N-AlGaAs/InGaAs/N-AlGaAs selectively-doped double-heterojunction fet" <br> * page 423, left-hand column, last paragraph; figures 2,4 * | 36-49 | |
| A | PATENT ABSTRACTS OF JAPAN vol. 8, no. 119 (E-248), 5 June 1984; <br> & JP - A - 59032174 (TOSHIBA) 21.02.1984 <br> * the whole document * | 38 | TECHNICAL FIELDS SEARCHED (Int. Cl.5) |
| | −/− | | |

The present search report has been drawn up for all claims

| Place of search | Date of completion of search | Examiner |
|---|---|---|
| Berlin | 26 July 91 | MUNNIX S J G |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document

EP 91 10 6033

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | JAPANESE JOURNAL OF APPLIED PHYSICS vol. 28, no. 2, February 1989, pages 200-209, Tokyo, JP; Y. HORIKOSHI et al.: "Growth mechanism of GaAs during migration-enhanced epitaxy at low growth temperatures" <br> * the whole document * <br> ― ― ― ― ― | 39 | |

TECHNICAL FIELDS SEARCHED (Int. Cl.5)

The present search report has been drawn up for all claims

| Place of search | Date of completion of search | Examiner |
|---|---|---|
| Berlin | 26 July 91 | MUNNIX S J G |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document